(19) Europäisches Patentamt
European Patent Office
Office européen des brevets

(11) Veröffentlichungsnummer : **0 047 902**
**B1**

(12) # EUROPÄISCHE PATENTSCHRIFT

(45) Veröffentlichungstag der Patentschrift : **07.11.84**

(51) Int. Cl.³ : **C 07 F 9/53**, C 07 F 9/32, C 07 F 9/65, C 08 F 2/50, C 08 K 5/50

(21) Anmeldenummer : **81106757.8**

(22) Anmeldetag : **29.08.81**

(54) **Acylphosphinsulfidverbindungen, ihre Herstellung und Verwendung.**

(30) Priorität : **15.09.80 DE 3034697**

(43) Veröffentlichungstag der Anmeldung : **24.03.82 Patentblatt 82/12**

(45) Bekanntmachung des Hinweises auf die Patenterteilung : **07.11.84 Patentblatt 84/45**

(84) Benannte Vertragsstaaten : **BE CH DE FR GB IT LI NL SE**

(56) Entgegenhaltungen :
**EP-A- 0 007 086**
**DE-A- 2 830 927**
**US-A- 3 668 093**
**HOUBEN-WEYL: "Methoden der organischen Chemie", 4. Auflage, Band XII, Teil 1, 1963 Georg Thieme Verlag, Stuttgart, DE, Seiten 168-171**

(73) Patentinhaber : **BASF Aktiengesellschaft**
**Carl-Bosch-Strasse 38**
**D-6700 Ludwigshafen (DE)**

(72) Erfinder : **Henne, Andreas, Dr.**
**Bruesseler Ring 34**
**D-6700 Ludwigshafen (DE)**
Erfinder : **Hesse, Anton, Dr.**
**Peter-Nickel-Strasse 15**
**D-6946 Luetzelsachsen (DE)**
Erfinder : **Heil, Guenter, Dr.**
**Dirmsteiner Weg 41**
**D-6700 Ludwigshafen (DE)**
Erfinder : **Schornick, Gunnar, Dr.**
**Konrad-Adenauer-Strasse 8**
**D-6719 Neuleiningen (DE)**

**EP 0 047 902 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die vorliegende Erfindung betrifft neue Acylphophinsulfid-verbindungen, ein Verfahren zur ihrer Herstellung und ihre Verwendung als Photoinitiatoren in photopolymerisierbaren Masse, wie Überzugsmittel, Lacke, Druckfarben, ungesättigte Polyesterformmassen sowie Aufzeichnungsmaterialien.

Es sind bereits eine Reihe von Photoinitiatoren verschiedener Strukturen bekannt, z. B. Benzildimethylketal (DE-B-2 261 383), Benzoinether (DE-B-1 694 149), Thioxanthone (DE-A-2 003 132). Photopolymerisierbare Massen, die mit derartigen Initiatorsystemen gehärtet werden, zeigen jedoch eine unerwünschte Vergilbung, die eine Verwendung dieser Systeme auf hellen (bzw. weißen) Flächen oder zur Härtung von transluzenten Formteilen fragwürdig macht. Ein weiterer Nachteil ist die oft ungenügende Lagerstabilität der fertig sensibilisierten Harzmischungen, die trotz Dunkellagerung häufig nur einige Tage haltbar sind. Ferner besteht ein Bedarf für Photoinitiatoren, die die bekannten oben genannten Systeme in ihrer Härtungsgeschwindigkeit übertreffen.

Aus der DE-A-2 830 927 sind auch bereits Acylphosphinoxid-Verbindungen und ihre Verwendung als Photoinitiatoren bekannt.

Ziel der vorliegenden Erfindung ist es, Verbindungen aufzuzeigen, die noch längerwellig absorbieren und sich als Photoinitiatoren eignen, durch die der Einsatz ungefährlicherer Lichtquellen bzw. die Härtung mit Sonnenlicht ermöglicht wird.

Gegenstand der vorliegenden Erfindung sind Acylphosphinsulfid-Verbindungen der allgemeinen Formel (I)

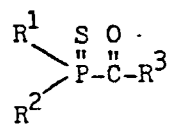

(I)

worin

$R^1$ für einen geradkettigen oder verzweigten Alkylrest mit 1 bis 6 Kohlenstoffatomen, den Cyclohexyl-, Cyclopentyl-, Phenyl- oder einen Naphthylrest, einen O-, S- oder N-haltigen fünf- oder sechsgliedrigen heterocyclischen Rest oder einen Fluor-, Chlor-, Brom-, $C_1$- bis $C_4$-alkyl- oder $C_1$- bis $C_4$-alkoxy-substituierten Phenyl-, Naphthyl-, O-, S- oder N-haltigen fünf- oder sechsgliedrigen heterocyclischen Rest, einen Dimethylphenyl-, Trimethylphenyl-, Dimethoxyphenyl oder Dichlorphenylrest steht ;

$R^2$ die Bedeutung von $R^1$ hat, wobei $R^1$ und $R^2$ untereinander gleich oder verschieden sein können, oder für einen Alkoxyrest mit 1 bis 6 Kohlenstoffatomen, einen Phenoxyrest, der gegebenenfalls Chlor-, $C_1$- bis $C_6$-alkyl- oder $C_1$- bis $C_6$-alkoxy-substituiert ist, oder einen Phenoxyalkylrest mit 1 bis 4 Kohlenstoffatomen in der Alkylgruppe steht oder $R^1$ und $R^2$ untereinander zu einem Ring verknüpft sind, der 4 bis 10 Kohlenstoffatome enthält und gegebenenfalls als Substituenten 1 bis 6 weitere Alkylreste mit je 1 bis 4 Kohlenstoffatomen sowie 1 oder 2 ankondensierte Benzolringe besitzen kann ;

$R^3$ für einen geradkettigen oder verzweigten Alkylrest mit 2 bis 18 Kohlenstoffatomen, einen 3 bis 12 Kohlenstoffatome enthaltenden cycloaliphtischen Rest, einen 1 bis 4-fach substituierten Phenyl-, einen gegebenenfalls 1- bis 4-fach substituierten Naphthyl-, O-, S- oder N-haltigen fünf- oder sechsgliedrigen heterocyclischen Rest, wobei diese Substituenten untereinander gleich oder verschieden und 1 bis 6 Kohlenstoffatome enthaltende Alkyl-, Alkylthio- oder Alkoxygruppen sowie Chlor-, Brom- oder Fluoratome sein können, oder für die Gruppierung

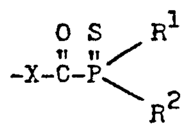

steht, worin $R^1$ und $R^2$ die oben angegebene Bedeutung haben und X für einen gegebenenfalls bis zu 4-fach substituierten Phenylenrest, dessen Substituenten untereinander gleich oder verschieden und 1 bis 6 Kohlenstoffatome enthaltende Alkyl-, Alkylthio- oder Alkoxygruppen sowie Fluor, Chlor oder Brom sein können, oder X für einen 2 bis 6 Kohlenstoffatome enthaltenden aliphatischen oder cycloaliphatischen zweiwertigen Rest steht.

Gegenstand der vorliegenden Erfindung ist außerdem ein Verfahren zur Herstellung dieser Acylphosphinsulfide, wobei Acylphosphine der allgemeinen Formel (II)

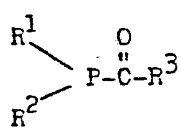

(II)

worin $R^1$ bis $R^3$ die oben angegebene Bedeutung haben, bei Temperaturen zwischen 20 und 200 °C,

vorzugsweise 60 bis 120 °C, gegebenenfalls in Anwesenheit eines inerten Lösungsmittels in einer Inertgasatmosphäre mit elementarem Schwefel umgesetzt werden.

Gegenstand der vorliegenden Erfindung ist ferner die Verwendung der Acylphosphinsulfide der allgemeinen Formel (I), als Photoinitiatoren in photopolymerisierbaren Massen, z. B. für Überzugsmittel, Lacke, Druckfarben sowie zur Herstellung von Kunststoff-Formteilen auf Basis ungesättigter Polyesterharze, wobei diese Acylphosphinsulfide gegebenenfalls auch in Kombination mit sekundären oder tertiären Aminen, anderen Photoinitiatoren oder Initiatoren für die thermische Polymerisation eingesetzt werden können.

Bevorzugt sind Acylphosphinsulfidverbindungen der allgemeinen Formel (I), bei denen $R^3$ ein tertiärer aliphatischer Rest ist. Ganz besonders bevorzugt sind solche Verbindungen, in denen $R^3$ für einen mindestens zweifach substituierten Phenyl-, Pyridyl-, Pyrrolyl-, Furyl- oder Thienylrest steht, der mindestens an den beiden zur Verknüpfungsstelle mit der Carbonylgruppe benachbarten Kohlenstoffatomen die Substituenten A und B trägt, die untereinander gleich der verschieden sein können und für 1 bis 6 Kohlenstoffatom enthaltende Alkyl-, Alkoxy- oder Alkylthioreste oder Fluor-, Chlor oder Brom, vorzugsweise Chlor- oder Brom-Atome stehen, oder $R^3$ für einen mindestens in den 2,8-Stellungen durch A und B substituierten α-Naphthylrest, einen mindestens in den 1,3-Stellungen durch A und B substituierten β-Naphthylrest oder für die Gruppierung

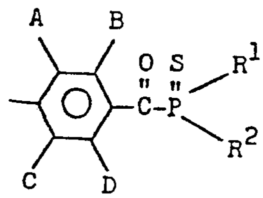

steht, wobei die Reste A, B, C und D untereinander gleich oder verschieden sind, C und D die gleiche Bedeutung haben wie A und B und $R^1$, $R^2$ die oben angegebene Bedeutung haben.

Bezüglich der allgemeinen Formel (I) der erfindungsgemäßen Acylphosphinsulfid-Verbindungen ist im einzelnen folgendes auszuführen :

$R^1$ kann sein ein geradkettiger oder verzweigter Alkylrest mit 1 bis 6 C-Atomen z. B. ein Methyl-, Ethyl-, i-Propyl-, n-Propyl-, n-Butyl-, sec.-Butyl-, iso-Butyl-, t-Butyl-, Amyl-, n-Hexylrest ; der Cyclopentyl-, Cyclohexylrest ; der Phenyl- oder ein Naphthylrest ; ein Fluor-, Chlor- oder Brom-substituierter Phenyl- oder Naphthylrest, wie Mono- oder Dichlorphenyl-, ein $C_1$- bis $C_4$-alkylsubstituierter Phenyl- oder Naphthylrest, wie z. B. ein Methylphenyl-, Ethylphenyl-, Isopropylphenyl-, tert.-Butylphenyl-, Dimethylphenyl-, Trimethylphenyl-, $C_1$- bis $C_4$-alkoxysubstituierter Phenyl- oder Naphthylrest z. B. ein Methoxyphenyl-, Ethoxyphenyl-, Dimethoxyphenylrest, O-, S- oder N-haltige fünf- oder sechsgliedrige heterocyclische Reste, z. B. Furyl-, Thienyl-, Pyridyl-, Pyrrolylrest, die ebenfalls Fluor-, Chlor-, Brom-, $C_1$- bis $C_4$-alkyl- oder $C_1$ bis $C_4$-alkoxyl-substituiert sein können, wie z. B. ein Methylfuryl- oder Chlorpyridylrest.

$R^2$ hat die Bedeutung von $R^1$, wobei $R^1$ und $R^2$ untereinander gleich oder verschieden sein können. Ferner kann $R^2$ stehen für einen Alkoxyrest mit 1 bis 6 Kohlenstoffatomen, einen Phenoxyrest, der gegebenenfalls Chlor-, $C_1$- bis $C_6$-alkyl- oder $C_1$- bis $C_6$-alkoxy-substituiert ist, oder einen Phenoxyalkylrest mit 1 bis 4 Kohlenstoffatomen in der Alkylgruppe. Schließlich können $R^1$ und $R^2$ untereinander zu einem phosphorhaltigen Ring verknüpft sein, der 4 bis 10 Kohlenstoffatome enthält und gegebenenfalls als Substituenten 1 bis 6 weitere Alkylreste mit je 1 bis 4 Kohlenstoffatomen sowie 1 oder 2 ankondensierte Benzolringe besitzen kann ;

$R^3$ kann sein ein geradkettiger oder verzweigter Alkylrest mit 2 bis 18 Kohlenstoffatomen, z. B. ein Ethyl-, i-Propyl-, n-Propyl-, n-Butyl-, i-Butyl-, i-Amyl-, n-Hexyl-, Heptyl-, n-Octyl-, 2-Ethylhexyl-, i-Nonyl-, Dimethylheptyl-, Dimethyloctyl-, Dimethylnonyl-, Dimethyldecyl-, Lauryl-, Stearyl-Rest, ein 3 bis 12 Kohlenstoffatome enthaltender cycloaliphatischer Rest, z. B. ein Cyclopropyl-, Cyclobutyl-, Cyclopentyl-, Cyclohexyl-, Norbornenyl-, Adamantylrest ; ein gegebenenfalls mit 1 bis 6 Kohlenstoffatome enthaltenden Alkyl-, Alkylthio- oder Alkoxygruppen oder mit Chlor, Brom oder Fluor 1- bis 4-fach substituierter Phenyl-, Naphthyl-, O-, S- oder N-haltiger fünf- oder sechsgliedriger Rest, z. B. Methylphenyl-, Dimethylphenyl-, Trimethylphenyl-, tert.-Butylphenyl-, Isopropylphenyl-, Methoxyphenyl-, Dimethoxyphenyl-, i-Propyloxyphenyl-, Methylthiophenyl-, α- und β-Naphthyl-, Thienyl-, Pyridyl-rest.

Bevorzugt kann $R^3$ sein ein t-Butyl-, ein 1-Methylcyclohexyl-, 1-Methylcyclopentyl-, 1,1-Dimethyloctylrest.

Besonders bevorzugt ist $R^3$ ein 2,6-Dimethylphenyl-, 2,6-Dimethoxyphenyl-, 2,6-Dichlorphenyl-, 2,6-Dibromphenyl-, 2-Chlor-6-methoxyphenyl-, 2-Chlor-6-methylthio-phenyl-, 2,4,6-Trimethylphenyl-, 2,4,6-Trimethoxyphenyl-, 2,3,4,6-Tetramethylphenyl, 2,6-Dimethyl-4-tert.-butylphenyl-, 1,3-Dimethylnaphthalin-2-, 2,8-Dimethylnaphthalin-1-, 1,3-Dimethoxy-naphthalin-2-, 1,3-Dichlornaphthalin-2-, 2,8-Dimethoxy-naphthalin-1-, 2,4,6-Trimethylpyridin-3-, 2,4-Dimethoxy-furan-3- oder ein 2,4,5-Trimethylthiophen-3-Rest.

Als Beispiele für die erfindungsgemäßen Acylphosphinsulfid-Verbindungen seien genannt :

Isobutyroyl-diphenylphosphinsulfid, 2-Ethylhexanoyl-diphenylphosphinsulfid, p-Toluyl-diphenylphosphinsulfid, o-Toluyl-diphenylphosphinsulfid, p-tert.-Butylbenzoyl-diphenylphosphinsulfid, 3-Pyridylcarbonyl-diphenylphosphinsulfid, Acryloyldiphenylphosphinsulfid, Benzoyl-diphenylphosphinsulfid, Terephthaloyl-bis-diphenylphosphinsulfid, Adipoyl-bis-diphenylphosphinsulfid und vorzugsweise Pivaloyl-diphenylphosphinsulfid, 1-Methyl-1-cyclohexancarbonyl-bis-(p-tolyl)phosphinsulfid, 2,2-Dimethylheptanoyl-diphenylphosphinsulfid und vorzugsweise

2,6-Dimethylbenzoyl-diphenylphosphinsulfid,
2,6-Dimethoxybenzoyl-diphenylphosphinsulfid,
2,4,6-Trimethylbenzoyldiphenylphosphinsulfid,
2,3,6-Trimethylbenzoyldiphenylphosphinsulfid,
2,4,6-Trimethoxybenzoyldiphenylphosphinsulfid,
2,6-Dichlorbenzoyldiphenylphosphinsulfid,
2-Chlor-6-methylthio-benzoyldiphenylphosphinsulfid,
2,6-Bis-(methylthio)-benzoyl-diphenylphosphinsulfid,
2,3,4,6-Tetramethylbenzoyldiphenylphosphinsulfid,
1,3-Dimethylnaphthalin-2-carbonyl-diphenylphosphinsulfid,
2,8-Dimethylnaphthalin-1-carbonyl-diphenylphosphinsulfid,
1,3-Dimethoxynaphthalin-2-carbonyl-diphenylphosphinsulfid,
1,3-Dichlornaphthalin-2-carbonyl-diphenylphosphinsulfid,
2,4,6-Trimethylpyridin-3-carbonyl-diphenylphosphinsulfid,
2,4-Dimethylfuran-3-carbonyl-diphenylphosphinsulfid,
2,4-Dimethoxyfuran-3-carbonyl-di(n-butyl)phosphinsulfid,
2,4,5-Trimethyl-thiophen-3-carbonyldiphenylphosphinsulfid,
2,4,5-Trimethyl-thiophen-3-carbonyl-diphenylphosphinsulfid,
2,6-Dimethoxybenzoyl-bis-(o-tolyl)-phosphinsulfid,
2,4,6-Trimethoxybenzoyl-bis-(p-tolyl)-phosphinsulfid,
2,6-Dimethoxybenzoyl-bis-(p-chlorphenyl)-phosphinsulfid,
2,4,6-Trimethoxybenzoyl-bis-(p-chlorphenyl)-phosphinsulfid,
2,6-Dimethoxybenzoyl-di-tert.-butylphosphinsulfid,
2,4,6-Trimethoxybenzoyl-di-tert.-butylphosphinsulfid,
2,3,5,6-Tetrachlorterephthaloyl-bis-diphenylphosphinsulfid.

Die Herstellung der erfindungsgemäßen Verbindungen kann bevorzugt in der Weise erfolgen, daß ein Acylphosphin der Formel (II)

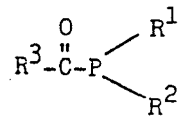

(II)

in Substanz oder in Gegenwart eines geeigneten inerten organischen Lösungsmittels in einer Inertgasatmosphäre von vorzugsweise Stickstoff, Argon oder Kohlendioxid bei einer Temperatur von 20 bis 200 °C, vorzugsweise von 60 bis 120 °C mit etwa äquimolaren Mengen elementarem Schwefel zur Reaktion gebracht wird. Bevorzugte Lösungsmittel sind Kohlenwasserstoffe wie Toluol, Cyclohexan, Chlorbenzol sowie aliphatische und aromatische Ether, wie Dibutylether, Dioxan, Diethylenglykoldimethylether oder Diphenylether. Die dabei entstehende Lösung des Acylphosphins wird durch Filtration von gegebenenfalls noch vorhandenem Schwefel abgetrennt. Nach Abdampfen des Lösungsmittels verbleibt das Acylphosphinsulfid, welches durch Destillation oder Umkristallisieren weiter gereinigt werden kann. Das Herstellverfahren läßt sich folgendermaßen beispielhaft beschreiben :

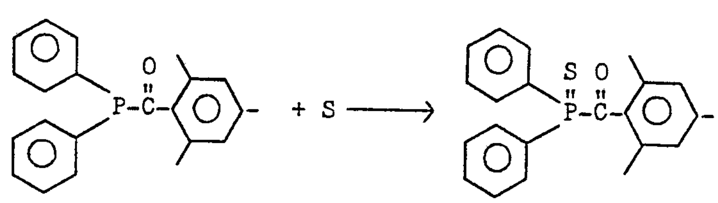

Die Gewinnung der Acylphosphine erfolgt nach Verfahren, die dem Fachmann aus der Literatur bekannt sind (s. z. B. H. Kunzek, J. Organometallic Chemistry, *49,* 149 (1973) und K. Issleib und O. Löw, Zeitschr. f. Anorganische und Analytische Chemie, *346,* 241 (1966)).

Auch die besonders bevorzugten Acylphosphinsulfidverbindungen lassen sich in der oben beschriebenen Weise aus den entsprechenden Acylphosphinverbindungen herstellen. Die Herstellung der dazu erforderlichen Acylphosphinverbindungen, in denen $R^3$ für einen mindestens zweifach substituierten Phenyl-, Pyridyl-, Pyrrolyl-, Furyl- oder Thienylrest steht, der mindestens in den beiden zur Verknüpfungsstelle mit der Carbonylgruppe benachbarten Kohlenstoffatomen die Substituenten A und B trägt, welche die oben angegebene Bedeutung haben oder in denen $R^3$ für einen mindestens in den 2,8-Stellungen durch A und B substituierten α-Naphthylrest oder einen mindestens in den 1,3-Stellungen durch A und B substituierten α-Naphthylrest oder für die Gruppe

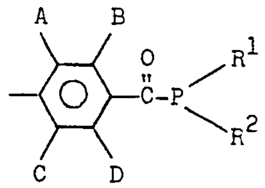

steht, mit gleichen oder verschiedenen Resten A, B, C, D, welche die für A, B oben angegebene Bedeutung haben, wird z. B. in der DE-A-3 020 092 beschrieben.

Geeignete Acylphosphine sind z. B. :

Benzoyldiphenylphosphin
p-Toluyldiphenylphosphin
o-Toluyl-diphenylphosphin

Geeignete Acylphosphine zur Herstellung der Bevorzugten

Acylphosphinsulfidverbindungen sind z. B. :

Pivaloyldiphenylphosphin,
2,2-Dimethylheptanoylditolylphosphin,
2-Methyl-2-ethylhexanoyldiphenylphosphin.

Geeignete Acylphosphine zur Herstellung der besonders bevorzugten Acylphosphinsulfidverbindungen sind z. B. :

2,6-Dimethylbenzoyldiphenylphosphin,
2,4,6-Trimethylbenzoyldiphenylphosphin,
2,6-Dimethoxybenzoyldiphenylphosphin,
2,6-Dichlorbenzoyldiphenylphosphin.

Beispiele für die erfindungsgemäßen Verbindungen sind, insbesondere folgende :

Tabelle 1

(Ph = Phenyl)

| Verbindung | Schmp. | Ausbeute | Analyse | C | H | P | S |
|---|---|---|---|---|---|---|---|
| 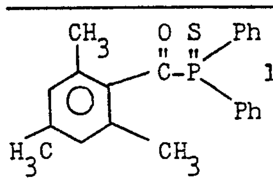 | 108-110° | 52,5 % | ber. | 72,53 | 5,77 | 8,52 | 8,79 |
| | | | gef. | 72,7 | 5,9 | 9,0 | 8,7 |
| 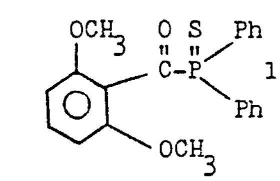 | 109-111° | 44,5% | ber. | 65,97 | 4,97 | 8,12 | 8,38 |
| | | | gef. | 65,9 | 5,0 | 8,4 | 7,9 |

Die erfindungsgemäßen Acylphosphinsulfidverbindungen zeigen eine sehr gute Reaktivität als Photoinitiatoren für photopolymerisierbare Monomere mit mindestens einer C-C-Mehrfachbindung und

Mischungen derselben miteinander und mit bekannten Zusatzstoffen. Die erfindungsgemäßen Acylphosphinsulfidverbindungen eignen sich besonders gut als Photoinitiatoren in photopolymerisierbaren Massen für Überzüge, Lacke, Druckfarben und Aufzeichnungsmaterialien. Sie sind hinsichtlich der Vergilbung der so erhaltenen Lacke bzw. Überzüge bekannten Photoinitiatoren, z. B. dem aus der DE-AS 2 261 383 bekannten Benzildimethylketal, weit überlegen. Die erfindungsgemäßen Acylphosphinsulfidverbindungen sind außerdem sehr vorteilhaft als Photoinitiatoren für die Lichthärtung von styrolischen Polyesterharzen, die gegebenenfalls Glasfasern und andere Hilfsstoffe enthalten können, verwendbar.

Als photopolymerisierbare Monomere eignen sich die üblichen Verbindungen und Stoffe mit polymerisierbaren C-C-Doppelbindungen, die durch z. B. Aryl-, Carbonyl-, Amino-, Amid-, Amido-, Ester-, Carboxy- oder Cyanid-Gruppen, Halogenatome oder zusätzliche C-C-Doppel- oder C-C-Dreifachbindungen aktiviert sind. Genannt seien beispielsweise Vinylether und Vinylester, mit 3 bis 10, vorzugsweise 4 bis 8 Kohlenstoffatomen, Vinylaromaten, wie Styrol, Vinyltoluol, Acrylsäure, und Methacrylsäure sowie deren Ester mit ein- oder mehrwertigen Alkoholen mit bis zu 20, vorzugsweise 1 bis 8 Kohlenstoffatomen, wie z. B. Methylmethacrylat, 2-Hydroxyethylacrylat, 2-Hydroxyethylmethacrylat, Butan-1,4-dioldiacrylat, Hexan-1,6-dioldiacrylat, Nitrile oder Amide der Acrylsäure bzw. Methacrylsäure, Malein- und Fumarester von Alkoholen mit 1 bis 20, vorzugsweise 1 bis 8 Kohlenstoffatomen, wie z. B. Fumarsäurediethylester sowie N-Vinylverbindungen, wie N-Vinylpyrrolidon, N-Vinylcaprolactam, N-Vinylcarbazol und Allylester wie Diallylphthalat.

Als photopolymerisierbare höhermolekulare Verbindungen sind beispielsweise geeignet: ungesättigte Polyester, hergestellt aus α,β-ungesättigten Dicarbonsäuren, wie Maleinsäure, Fumarsäure oder Itaconsäure, gegebenenfalls im Gemisch mit gesättigten bzw. aromatischen Dicarbonsäuren wie Adipinsäure, Phthalsäure oder Terephthalsäure, durch Umsetzung mit Alkandiolen wie Ethylenglykol, Propylenglykol, Butandiol, Neopentylglykol oder oxalkyliertem Bisphenol A; Epoxidacrylate, hergestellt aus Acryl- oder Methacrylsäure und aromatischen oder aliphatischen Diglycidethern und Urethancrylate (z. B. hergestellt aus Hyroxyalkylacrylaten und Polyisocyanaten) sowie Polyesteracrylate (z. B. hergestellt aus hydroxylgruppenhaltigen gesättigten Polyestern und Acryl- oder Methacrylsäure).

Den photopolymerisierbaren Verbindungen, deren Zusammensetzung für den jeweiligen Verwendungszweck dem Fachmann geläufig ist, können in bekannter Weise gesättigte und/oder ungesättigte Polymere sowie weitere Zusatzstoffe wie Inhibitoren gegen die thermische Polymerisation, Paraffin, Pigmente, Farbstoffe, Peroxide, Verlaufshilfsmittel, Füllstoffe und Glasfasern sowie Stabilisatoren gegen thermischen oder photochemischen Abbau zugesetzt sein.

Solche Gemische sind dem Fachmann bekannt. Art und Menge der Zusätze hängen vom jeweiligen Verwendungszweck ab.

Die erfindungsgemäßen Acylphosphinsulfid-Verbindungen werden dabei im allgemeinen in einer Konzentration von 0,01 bis 15 Gew.%, vorzugsweise 0,05 bis 5 Gew.%, bezogen auf die photopolymerisierbare Masse eingesetzt. Sie können gegebenenfalls mit Beschleunigern kombiniert werden, die den hemmenden Einfluß des Luftsauerstoffs auf die Photopolymerisation beseitigen.

Solche Beschleuniger bzw. Synergisten sind beispielsweise sekundäre und/oder tert. Amine, wie Methyldiethanolamin, Dimethylethanolamin, Triethylamin, Triethanolamin, p-Dimethylaminobenzoesäureethylester, Benzyl-dimethylamin, Dimethylaminoethylacrylat, N-Phenylglycin, N-Methyl-N-phenylglycin und analoge, dem Fachmann bekannte Verbindungen. Zur Beschleunigung der Aushärtung können weiterhin aliphatische und aromatische Halogenide dienen wie 2-Chlormethylnaphthalin, 1-Chlor-2-chlormethyl-naphthalin sowie gegebenenfalls Radikalbildner, wie sie im allgemeinen als Initiatoren für die thermische Polymerisation eingesetzt werden, z. B. Peroxide, Azo-Verbindungen sowie C-C-labile Verbindungen, die in Mengen von bis zu 15 Gew.%, bezogen auf die photopolymerisierbare Masse, zugesetzt werden können und dem Fachmann bekannt sind.

Ferner können die Acylphosphinsulfidverbindungen, gegebenenfalls in Anwesenheit der oben bezeichneten Synergisten und Beschleuniger, in Kombination mit anderen Photoinitiatoren zur Lichthärtung von Überzügen, Lacken, Druckfarben, photosensible Aufzeichnungsmaterialien, wie z. B. photopolymerisierbare Druckplatten und styrolischen Polyesterharzen eingesetzt werden. Solche Photoinitiatoren sind z. B. aromatische Ketone wie Benzilketale, Benzoinether, Benzoinester, $C_1$- bis $C_3$-alkyl, chlor- oder chlormethylsubstituierte Thioxanthone, die in der DE-A-3 020 092 beschriebenen Acylphosphine sowie die aus DE-OS 2 830 927 und DE-OS 2 909 994 bekannten Acylphosphinoxide und Acylphosphinsäureester. Ferner zählen dazu aromatische Disulfide und Naphthalinsulfochloride. Diese und gegebenenfalls weitere geeignete Verbindungen sind dem Fachmann bekannt.

Als Strahlungsquellen für das die Polymerisation solcher Mischungen auslösende Licht verwendet man im allgemeinen solche, die Licht vorzugsweise im Absorptionsbereich der erfindungsgemäßen Verbindungen aussenden, d. h. zwischen 230 und 450 nm. Besonders geeignet sind Quecksilber-Niederdruckstrahler, -Mitteldruck- und Hochdruckstrahler sowie superaktinische Leuchtstoffröhren oder Impulsstrahler. Die genannten Lampen können gegebenenfalls dotiert sein.

Ein besonderer Vorteil der erfindungsgemäßen Acylphosphinsulfide ist, daß sie sich als Photoinitiatoren eignen, mit denen die Photopolymerisation mit längerwelligeren und damit ungefährlicheren Lichtquellen wie Leuchtstoffröhren bzw. die Härtung mit Sonnenlicht möglich ist.

Die in den nachstehenden Beispielen genannten Teile und Prozente beziehen sich, soweit nicht

anders angegeben, auf das Gewicht. Volumenteile verhalten sich zu Teilen wie Liter zu Kilogramm.

Beispiel 1

7,0 Teile 2,6-Dimethoxy-benzoyl-diphenylphosphin (vgl. Beispiel 1 der DE-A-3 020 092) werden in 60 Volumenteilen Toluol gelöst und die Lösung 30 min mit Stickstoff gespült. Dann werden 0,64 Teile Schwefel zugegeben. Diese Lösung wird in Stickstoffatmosphäre 4 Stunden bei 60 °C gerührt. Dann wird abgekühlt und das Lösungsmittel im Vakuum abgezogen. Der Rückstand wird aus Toluol umkristallisiert.

Ausbeute : 3,4 Teile 2,6-Dimethoxybenzoyldiphenylphosphinsulfid (44,5 % d. Th.) Schmp. 109-111 °C ; NMR ($CDCl_3$, δ) : 3,56 (s, 6 H) ; 6,52 (d, 2 H) ; 7,2-8,2 (m, 11 H)

Analyse $C_{21}H_{19}O_3PS$ (382)

ber. : C 65,97 H 4,97 P 8,12 S 8,38

gef. : C 65,9 H 5,0 P 8,4 S 7,9

Beispiel 2

6,6 Teile 2,4,6-Trimethylbenzoyldiphenylphosphin (vgl. Beispiel 2 der DE-A-3 020 092) werden in 60 Volumenteilen Toluol gelöst und die Lösung 30 min mit Stickstoff gespült. Dann werden 0,64 Teile Schwefel zugegeben. Diese Lösung wird in einer Stickstoffatmosphäre 2 Stunden bei 60 °C gerührt. Dann wird abgekühlt und das Lösungsmittel im Vakuum abgezogen. Der Rückstand wird aus Diethylether umkristallisiert.

Ausbeute : 3,6 Teile (52,5 % d. Th.)

Schmp. 108-110 °C ; NMR ($CDCl_3$, δ) : 1,98 (s, 6 H) ; 2,28 (s, 3 H) ; 6,81 (s, 2 H) ; 7,2-7,8 (m, 6 H) ; 7,8-8,4 (m, 4 H).

Analyse $C_{22}H_{21}OPS$ (364)

ber. : C 72,53 H 5,77 P 8,52 S 8,79

gef. : C 72,7 H 5,9 P 8,7 S 9,0

Beispiel 3

Zur Messung der Härtungsaktivität der erfindungsgemäßen Verbindungen wurde der Temperaturverlauf in ungesättigtem Polyesterharz (UP-Harz) während der UV-Belichtung aufgezeichnet ; dazu taucht ein mit einer Wachsschicht überzogener Thermofühler, der mit einem Temperaturschreiber (Tastotherm Script 3 N, Standardfühler T 300 der Deutschen Gulton GmbH) verbunden ist, in einen mit 10 g UP-Harz gefüllten Weißblechdeckel mit einem Durchmesser von 5 cm (Schichtdicke des UP-Harzes 4,8 mm). Zur Vermeidung von Wärmeverlusten während der UV-Belichtung ist der Deckel in Polyurethan-Hartschaum eingebettet. Als Strahlungsquelle dient ein UV-Feld aus 5 Leuchtstoffröhren (TLAK 40 W/05, Philips) nebeneinander. Der Abstand Strahler/UP-Harzoberfläche betrug 8,5 cm.

Aus den registrierten Temperatur-Zeitkurven werden als charakteristische Kenngrößen für die Härtungsaktivität die Härtungszeit HZ 25 °C-$T_{max}$ und die maximal erreichte Härtungstemperatur $T_{max}$ enthommen. Als Härtungszeit HZ 25 °C-$T_{max}$ gilt die Zeitspanne, in der die Probentemperatur von 25 °C auf $T_{max}$ ansteigt.

Die Beispiele und Vergleichsbeispiele wurden mit folgenden ungesättigten Polyesterharzen durchgeführt :

Harz A ist eine mit 0,01 % Hydrochinon stabilisierte 65 %ige styrolische Lösung eines ungesättigten Polyesters aus Maleinsäure, o-Phthalsäure, Ethylenglykol und Propylenglykol-1,2 im Molverhältnis 1 : 2 : 2,3 : 0,70. Der ungesättigte Polyester hat eine Säurezahl von 50.

Harz B ist eine mit 0,01 % Hydrochinon stabilisierte 66 %ige styrolische Lösung eines ungesättigten Polyesters aus Maleinsäure, o-Phthalsäure und Propylenglykol-1,2 im Molverhältnis 1 : 0,5 : 1,5. Der ungesättigte Polyester hat eine Säurezahl von 50.

Harz C ist eine mit 0,012 % Hydrochinon stabilisierte 65 %ige styrolische Lösung eines ungesättigten Polyesters aus Maleinsäure, o-Phthalsäure, Propylenglykol-1,2 und Diethylenglykol im Molverhältnis 1 : 0,25 : 1 : 0,25. Der ungesättigte Polyester hat eine Säurezahl von 43.

Harz D ist eine mit 0,01 % Hydrochinon stabilisierte 67 %ige styrolische Lösung eines ungesättigten Polyesters aus Maleinsäure, Tetrahydrophthalsäure und Diethylenglykol im Molverhältnis 1 : 0,5 : 1,5. Der ungesättigte Polyester hat eine Säurezahl von 43.

Harz E ist eine mit 0,01 % Hydrochinon stabilisierte 65 %ige styrolische Lösung eines ungesättigten Polyesters aus Maleinsäure, Isopthalsäure, Propylenglykol-1,2 und Diethylenglykol im Molverhältnis 1 : 0,67 : 0,72 : 1. Der ungesättigte Polyester hat eine Säurezahl von 26.

Als UV-Sensibilisatoren wurden für Vergleichsbeispiele folgende zum Stand der Technik gehörende Verbindungen eingesetzt :

I Benzildimethylketal
II Benzoinmethylether
III Benzoinisopropylether
IV Methylolbenzoinmethylether.

Diese wurden mit den beiden erfindungsgemäßen Photoinitiatoren

V 2,6-Dimethoxybenzoyldiphenylphosphinsulfid und
VI 2,4,6-Trimethylbenzoyldiphenylphosphinsulfid

verglichen. Die Ergebnisse sind der Tabelle 2 zu entnehmen.

Tabelle 2

UV-Härtung sensibilisierter UP-Harze durch Belichtung mit Leuchstoffröhren

| UP-Harz | UV-Initiator (0,2 %) | $HZ_{25^oC-T_{max}}$ [min/s] | $T_{max}$ [°C] |
|---|---|---|---|
| A | I | 8/00 | 114 |
| B | I | 9/45 | 119 |
| C | I | 10/15 | 123 |
| D | I | 8/30 | 122 |
| A | II | 23/22 | 104 |
| B | II | 12/07 | 109 |
| C | II | 13/15 | 114 |
| D | II | 11/15 | 108 |
| A | III | 13/22 | 100 |
| B | III | 11/30 | 117 |
| C | III | 11/15 | 123 |
| D | III | 9/08 | 122 |
| A | IV | 7/30 | 107 |
| B | IV | 6/45 | 116 |
| C | IV | 6/38 | 123 |
| D | IV | 5/30 | 123 |
| A | V (0,1 %) | 5/08 | 102 |
| B | V (0,2 %) | 3/33 | 138 |
| C | V (0,2 %) | 3/38 | 148 |
| D | V (0,2 %) | 3/20 | 136 |
| E | V (0,2 %) | 3/50 | 130 |
| A | VI (0,1 %) | 5/54 | 105 |
| B | VI (0,2 %) | 4/00 | 135 |
| C | VI (0,2 %) | 3/45 | 142 |
| D | VI (0,2 %) | 3/40 | 126 |
| E | VI (0.2 %) | 4/15 | 130 |

Die erfindungsgemäßen Photoinitiatoren weisen eine gegenüber den handelüblichen (I-IV) deutlich höhere Wirksamkeit auf ; außerdem ist die Formstoffvergilbung geringer.

Beispiel 4

In einem Bindemittel aus 65 Teilen eines Umsetzungsproduktes aus Bisphenol-A-glycidether und Acrylsäure, 35 Teilen Hexan-1,6-dioldiacrylat werden 3 Teile Photoinitiator gelöst. Die fertige Mischung wird auf Glasplatten in einer Schicht von 60 μ Dicke aufgerackelt und in 10 cm Abstand unter einer Quecksilberhochdrucklampe (Leistung 80 W/cm Bogenlänge) vorbeigeführt. Die Reaktivität ist als die maximal mögliche Transportbandgeschwindigkeit angegeben, bei der noch eine nagelharte kratzfeste Aushärtung des Überzuges erzielt wird. Die Ergebnisse sind in Tabelle 3 zusammengestellt.

Beispiel 5

Zu einem nach Beispiel 4 hergestellten Lack werden 3 % Methyldiethanolamin gegeben. Anschließend wird wie in Beispiel 4 auf Glasplatten aufgezogen und belichtet. Die Ergebnisse sind in Tabelle 3 zusammengefaßt. Danach läßt sich die Härtungsgeschwindigkeit der erfindungsgemäßen Verbindungen durch Zusatz eines Aminbeschleunigers erhöhen.

Tabelle 3

| Photoinitiator | maximale Transportbandgeschwindigkeit in m/min | | |
|---|---|---|---|
| | unter Luft | unter Intertgas | unter Luft, bei Zusatz von 3 % Methyldiethanolamin |
| 2,4,6-Trimethylbenzoyldiphenylphosphinsulfid | <12 | 140 | 24 |
| 2,6-Dimethoxybenzoyldiphenylphosphinsulfid | <12 | 150 | 24 |

**Ansprüche**

1. Acylphosphinsulfid-Verbindungen der allgemeinen Formel (I)

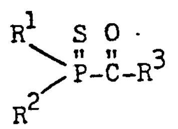

(I)

worin

$R^1$ für einen geradkettigen oder verzweigten Alkylrest mit 1 bis 6 Kohlenstoffatomen, den Cyclohexyl-, Cyclopentyl-, Phenyl- oder einen Naphthylrest, einen O-, S- oder N-haltigen fünf- oder sechsgliedrigen heterocyclischen Rest oder einen Fluor-, Chlor-, Brom-, $C_1$- bis $C_4$-alkyl- oder $C_1$- bis $C_4$-alkoxy-substituierten Phenyl-, Naphthyl-, O-, S- oder N-haltigen fünf- oder sechsgliedrigen Heterocyclischen Rest, einen Dimethylphenyl-, Trimethylphenyl-, Dimethoxyphenyl- oder Dichlorphenylrest steht ;

$R^2$ die Bedeutung von $R^1$ hat, wobei $R^1$ und $R^2$ untereinander gleich oder verschieden sein können, oder für einen Alkoxyrest mit 1 bis 6 Kohlenstoffatomen, einen Phenoxyrest, der gegebenenfalls Chlor-, $C_1$- bis $C_6$-alkyl- oder $C_1$- bis $C_6$-alkoxy-substituiert ist, oder einen Phenoxyalkylrest mit 1 bis 4 Kohlenstoffatomen in der Alkylgruppe steht oder $R^1$ und $R^2$ untereinander zu einem Ring verknüpft sind, der 4 bis 10 Kohlenstoffatome enthält und gegebenenfalls als Substituenten 1 bis 6 weitere Alkylreste mit je 1 bis 4 Kohlenstoffatomen sowie 1 oder 2 ankondensierte Benzolringe besitzen kann ;

$R^3$ für einen geradkettigen oder verzweigten Alkylrest mit 2 bis 18 Kohlenstoffatomen, einen 3 bis 12 Kohlenstoffatome enthaltenden cycloaliphatischen Rest, einen 1- bis 4-fach substituierten Phenyl-, einen gegebenenfalls 1 bis 4-fach substituierten Naphthyl-, O-, S- oder N-haltigen fünf- oder sechsgliedrigen

heterocyclischen Rest, wobei diese Substituenten untereinander gleich oder verschieden und 1 bis 6 Kohlenstoffatome enthaltende Alkyl-, Alkylthio- oder Alkoxygruppen sowie Chlor-, Brom- oder Fluoratome sein können, oder für die Gruppierung

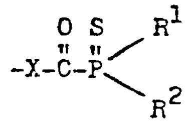

steht, worin $R^1$ und $R^2$ die oben angegebene Bedeutung haben und X für einen gegebenenfalls bis zu 4-fach substituierten Phenylenrest steht, wobei dessen Substituenten untereinander gleich oder verschieden und 1 bis 6 Kohlenstoffatome enthaltende Alkyl-, Alkylthio- oder Alkoxygruppen sowie Fluor, Chlor oder Brom sein können, oder X für einen 2 bis 6 Kohlenstoffatome enthaltenden aliphatischen oder cycloaliphatischen zweiwertigen Rest steht sowie Acryloyldiphenylphosphinsulfid.

2. Acylphosphinsulfidverbindungen nach Anspruch 1, dadurch gekennzeichnet, daß $R^3$ ein tertiärer aliphatischer Rest ist.

3. Acylphosphinsulfidverbindungen nach Anspruch 1, dadurch gekennzeichnet, daß $R^3$ für einen mindestens zweifach substituierten Phenyl-, Pyridyl-, Pyrrolyl-, Furyl- oder Thienylrest steht, der mindestens an den beiden zur Verknüpfungsstelle mit der Carbonylgruppe benachbarten Kohlenstoffatomen die Substituenten A und B trägt, die untereinander gleich oder verschieden sein können und für 1 bis 6 Kohlenstoffatome enthaltende Alkyl-, Alkoxy- oder Alkylthioreste, oder Fluor, Chlor oder Brom stehen oder $R^3$ für einen mindestens in den 2,8-Stellungen durch A und B substituierten α-Naphthylrest, einen mindestens in 1,3-Stellungen durch A und B substituierten β-Naphthylrest oder für die Gruppierung

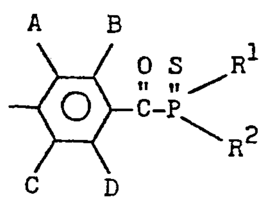

steht, wobei die Reste A, B, C und D untereinander gleich oder verschieden sind, C und D die gleiche Bedeutung haben wie A bzw. B und $R^1$ und $R^2$ die in Anspruch 1 angegebene Bedeutung haben.

4. Acylphosphinsulfidverbindungen nach Anspruch 3, dadurch gekennzeichnet, daß $R^3$ ein 2,6-Dimethylphenyl, 2,4,6-Trimethylphenyl-, 2,3,6-Trimethylphenyl-, 2,6-Dimethoxyphenyl-, 2,6-Dichlorphenyl-, 2,6-Bis(methylthio)- phenyl, ein 2,3,5,6-Tetramethylphenyl-, ein 2,4,6-Trimethylpyridyl-3-, ein 2,4-Dimethylthienyl-3-, ein 1,3-Dimethylnaphthalin-2-, ein 2,8-Dimethylnaphthalin-1-, ein 1,3-Dimethoxynaphthalin-2- oder ein 2,8-Dimethoxynaphthalin-1-Rest ist.

5. Verfahren zur Herstellung der Acylphosphinsulfide nach Anspruch 1 bis 4, dadurch gekennzeichnet, daß man Acylphosphine der allgemeinen Formel (II)

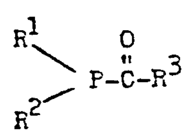
(II)

worin $R^1$ bis $R^3$ die oben angegebene Bedeutung haben, bei Temperaturen zwischen 20 und 200 °C, gegebenenfalls in Anwesenheit eines inerten Lösungsmittels in einer Inertgasatmosphäre mit elementarem Schwefel umsetzt.

6. Verwendung der Acylphosphinsulfide nach Anspruch 1 bis 4 als Photoinitiatoren in photopolymerisierbaren Massen.

7. Verwendung der Acylphosphinsulfide nach Anspruch 6 in Kombination mit sekundären und/oder tertiären Aminen.

8. Verwendung der Acylphosphinsulfid-Verbindungen nach einem der Ansprüche 1 bis 4 als Photoinitiatoren in photopolymerisierbaren Überzugsmitteln, Lacken, Druckfarben und Aufzeichnungsmaterialien, wobei diese den Photoinitiator in einer Konzentration von 0,01 % bis 15 % enthalten.

9. Verwendung nach Anspruch 6 oder 7 zur Herstellung von Kunststoff-Formteilen auf Basis ungesättigter Polyesterharze, die gegebenenfalls weitere Hilfsstoffe, insbesondere Glasfasern, enthalten.

10. Verwendung nach Anspruch 6, 7 oder 9, dadurch gekennzeichnet, daß als UV-Sensibilisatoren Acylphosphinsulfid-Verbindungen der allgemeinen Formel (I) in Kombination mit Verbindungen aus der Gruppe der Benzilketale, Benzoinether, Benzoinester, $C_1$- bis $C_4$-alkyl-, chlor- oder chlormethylsubstituierten Thioxanthone, aromatischen Disulfide, Naphthalinsulfochloride, Acylphosphine, Acylphosphinoxide und Acylphosphinsäureester eingesetzt werden.

11. Verwendung der Acylphosphinsulfide nach Anspruch 6, 7, 9 oder 10, dadurch gekennzeichnet, daß die Acylphosphinsulfidverbindung in Kombination mit Initiatoren für die thermische Polymerisation eingesetzt werden.

**Claims**

1. An ancylphosphine sulfide compound of the general formula (I)

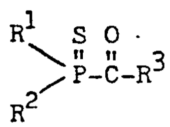
(I)

where

$R^1$ is straight-chain or branched alkyl of 1 to 6 carbon atoms, cyclohexyl or cyclopentyl, or a phenyl, naphthyl or O-, S- or N-containing 5- or 6-membered heterocyclic radical which is unsubstituted or substituted by fluorine, chlorine, bromine, $C_1$-$C_4$-alkyl or $C_1$-$C_4$-alkoxy, or dimethylphenyl, trimethylphenyl, dimethoxyphenyl or dichlorophenyl ;

$R^2$ has the meanings of $R^1$ and can be identical to or different from $R^1$, or is alkoxy of 1 to 6 carbon atoms, phenoxy which is unsubstituted or substituted by chlorine, $C_1$-$C_6$-alkyl or $C_1$-$C_6$-alkoxy, or phenoxyalkyl, where alkyl is of 1 to 4 carbon atoms, or $R^1$ and $R^2$ are linked together to form a ring of 4 to 10 carbon atoms which is unsubstituted or can contain 1 to 6 further alkyl substituents, each of 1 to 4 carbon atoms, as well as 1 or 2 fused-on benzene rings ;

$R^3$ is straight-chain or branched alkyl of 2 to 18 carbon atoms, a cycloaliphatic radical of 3 to 12 carbon atoms, mono-, di-, tri- or tetra-substituted phenyl or an unsubstituted or mono-, di-, tri- or tetra-substituted naphthyl or O-, S- or N-containing 5- or 6-membered heterocyclic radical, where the substituents can be identical or different and can be alkyl, alkylthio or alkoxy of 1 to 6 carbon atoms or chlorine, bromine or fluorine, or the group

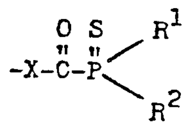

where $R^1$ and $R^2$ have the above meanings and X is unsubstituted or mono-, di-, tri- or tetra-substituted phenylene, where the substituents can be identical or different and can be alkyl, alkylthio or alkoxy of 1 to 6 carbon atoms or fluorine, chlorine or bromine, or X is an aliphatic or cycloaliphatic divalent radical of 2 to 6 carbon atoms, and acryloyldiphenylphosphine sulfide.

2. An acylphosphine sulfide compound as claimed in claim 1, where $R^3$ is a tertiary aliphatic radical.

3. An acylphosphine sulfide compound as claimed in claim 1, where $R^3$ is phenyl, pyridyl, pyrrolyl, furyl or thienyl which is not less than disubstituted and bears, at least on the two carbon atoms adjacent to the point of attachment to the carbonyl group, the substituents A and B, which can be identical or different and are alkyl, alkoxy or alkylthio of 1 to 6 carbon atoms, or fluorine, chlorine or bromine, or $R^3$ is α-naphthyl which is substituted by A and B at least in the 2,8-positions, β-naphthyl which is substituted by A and B at least in the 1,3-positions or the group

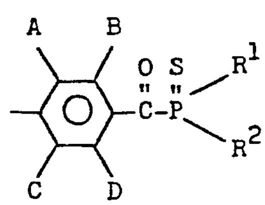

where A, B, C and D are identical or different, C and D have the same meanings as A and B, and $R^1$ and $R^2$ have the meanings given in claim 1.

4. An acylphosphine sulfide compound as claimed in claim 3, where $R^3$ is 2,6-dimethylphenyl, 2,4,6-trimethylphenyl, 2,3,6-trimethylphenyl, 2,6-dimethoxyphenyl, 2,6-dichlorophenyl, 2,6-bis-(methylthio)-phenyl, 2,3,5,6-tetramethylphenyl, 2,4,6-trimethylpyrid-3-yl, 2,4-dimethylthien-3-yl, 1,3-dimethylnaphth-2-yl, 2,8-dimethylnaphth-1-yl, 1,3-dimethoxynaphth-2-yl or 2,8-dimethyloxynaphth-1-yl.

5. A process for the preparation of an acylphosphine sulfide as claimed in claims 1 to 4, wherein an acylphosphine of the general formula (II)

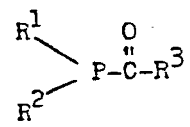

(II)

where $R^1$, $R^2$ and $R^3$ have to above meanings, is reacted with elementary sulfur at from 20 to 200 °C in the presence or absence of an inert solvent and under an inert gas atmosphere.

6. The use of an acylphosphine sulfide as claimed in claims 1 to 4 as a photoinitiator in photopolymerizable compositions.

7. The use of an acylphosphine sulfide as claimed in claim 6, in combination with a secondary and/or tertiary amine.

8. The use of an acylphosphine sulfide compound as claimed in any of claims 1 to 4 as a photoinitiator in photopolymerizable coating materials, paints, printing inks or recording materials, the photoinitiator being present therein in a concentration of from 0.01 % to 15 %.

9. The use as claimed in claim 6 or 7 for the production of plastic moldings based on an unsaturated polyester resin which may contain further auxiliaries, in particular glass fibers.

10. The use as claimed in claim 6, 7 or 9, wherein an acylphosphine sulfide compound of the general formula (I) is used as a UV sensitizer in combination with a compound from the group comprising benzil ketals, benzoin ethers, benzoin esters, $C_1$-$C_4$-alkyl-, chloro- or chloromethyl-substituted thioxanthones, aromatic disulfides, naphthalenesulfonyl chlorides, acylphosphines, acylphosphine oxides and acylphosphinic acid esters.

11. The use of an acylphosphine sulfide, as claimed in claim 6, 7, 9 or 10, wherein the acylphosphine sulfide compound is used in combination with an initiator for thermal polymerization.

**Revendications**

1. Sulfures d'acylphosphines de formule générale (I)

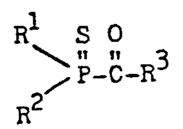

(I)

dans laquelle

$R^1$ représente un reste alkyle, à chaîne droite ou ramifiée, ayant 1 à 6 atomes de carbone, le reste cyclohexyle, cyclopentyle, phényle ou un reste naphtyle, un reste hétérocyclique à cinq ou six chaînons contenant O, S ou N, ou un reste hétérocyclique à cinq ou six chaînons contenant O, S, ou N, naphtyle ou phényle substitués par fluor, chlore, brome, alkyle en $C_1$ à $C_4$, ou alcoxy en $C_1$ à $C_4$, un reste diméthylphényle, triméthylphényle, diméthoxyphényle ou dichlorophényle,

$R^2$ a la signification de $R^1$, $R^1$ et $R^2$ pouvant être identiques ou différents, ou bien représente un reste alcoxy ayant 1 à 6 atomes de carbone, un reste phénoxy, éventuellement substitué par chlore, alkyle en $C_1$ à $C_6$ ou alcoxy en $C_1$ à $C_6$, ou un reste phénoxyalkyle ayant 1 à 4 atomes de carbone dans le groupe alkyle, ou bien $R^1$ et $R^2$ sont liés en un noyau qui contient 4 à 10 atomes de carbone et peut posséder éventuellement, comme substituants, 1 à 6 autres restes alkyle ayant chacun 1 à 4 atomes de carbone ainsi que 1 ou 2 chaînes benzène fixées par condensation,

$R^3$ représente un reste alkyle, à chaîne linéaire ou ramifiée, ayant 2 à 18 atomes de carbone, un reste cycloaliphatique contenant 3 à 12 atomes de carbone, un reste hétérocyclique à cinq ou six chaînons contenant phényle substitué 1 à 4 fois, naphtyle substitué 1 à 4 fois, O, S ou N, ces substituants pouvant être identiques ou différents et être des groupes alkyle, alkylthio, ou alcoxy, contenant 1 à 6 atomes de carbone ou être des atomes de chlore, brome ou fluor ou le groupement

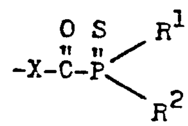

où $R^1$ et $R^2$ ont la signification donnée plus haut et X représente un reste phénylène éventuellement substitué jusqu'à 4 fois, les substituants étant identiques ou différents et être des groupes alkyle, alkylthio, ou alcoxy contenant 1 à 6 atomes de carbone, ainsi que fluor, chlore ou brome, ou bien X représente un reste divalent aliphatique ou cycloaliphatique, contenant 2 à 6 atomes de carbone, ainsi que sulfure d'acryloyldiphénylphosphine.

2. Sulfures d'acylphosphines selon la revendication 1, caractérisés par le fait que $R^3$ est un reste aliphatique tertiaire.

3. Sulfures d'acylphosphines selon la revendication 1, caractérisés par le fait que $R^3$ représente un reste phényle, pyridyle pyrrolyle, furyle ou thiényle substitué au moins deux fois, qui, au moins sur les deux atomes de carbone voisins des groupes carbonyle, à la zone de liaison, porte les substituants A et B, qui peuvent être identiques ou différents et représentent des restes alkyle, alcoxy, ou alkylthio contenant 1 à 6 atomes de carbone, ou fluor, chlore ou brome, ou bien $R^3$ représente un reste α-naphtyle substitué, au moins en positions 2, 8 par A et B, un reste β-naphtyle substitué, au moins en position 1, 3, par A et B ou le groupement

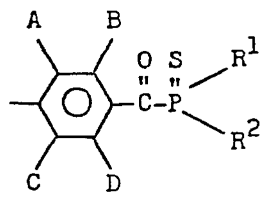

les restes A, B, C et D étant identiques ou différents, C et D ayant la même signification que A ou B et $R^1$ et $R^2$ ayant la signification indiquée dans la revendication 1.

4. Sulfures d'acylphosphine selon la revendication 3, caractérisés par le fait que $R^3$ représente un reste 2,6-diméthylphényle, 2,4,6-triméthylphényle, 2,3,6-triméthylphényle, 2,6-diméthoxyphényle, 2,6-dichlorophényle, 2,6-bis(méthylthio)-phényle, 2,3,5,6-tétraméthylphényle, 2,4,6-triméthylpyridyle-3, 2,4-diméthylthiényle-3, 1,3-diméthylnaphtalène-2, 2,8-diméthylnaphtalène-1, 1,3-diméthoxynaphtalène-2 ou 2,8-diméthoxynaphtalène-1.

5. Procédé de préparation des sulfures d'acylphosphines, selon les revendications 1 à 4, caractérisé par le fait qu'on fait réagir avec du soufre élémentaire des acylphosphines de formule générale (II)

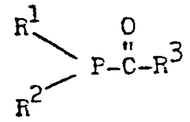

(II)

où $R^1$ à $R^3$ ont les significations indiquées plus haut, à des températures comprises entre 20 et 200 °C, éventuellement en présence d'un solvant inerte en atmosphère de gaz inerte.

6. Utilisation des sulfures d'acylphosphines selon les revendications 1 à 4, comme photoinitiateurs en masses photopolymérisables.

7. Utilisation des sulfures d'acylphosphines selon la revendication 6, en combinaison avec des amines secondaires et/ou tertiaires.

8. Utilisation des sulfures d'acylphosphines selon l'une des revendications 1 à 4, comme photoinitiateurs en agents d'enduction photopolymérisables, laques, encres d'impression et matériaux d'enregistrement, ceux-ci contenant le photoinitiateur en concentration de 0,01 % à 15 %.

9. Utilisation selon les revendications 6 ou 7 pour la fabrication de pièces moulées en matière plastique, à base de résines polyester insaturées, qui contiennent éventuellement d'autres auxiliaires, en particulier des fibres de verre.

10. Utilisation selon les revendications 6, 7 ou 9, caractérisée par le fait qu'on introduit comme sensibilisateur UV, des sulfures d'acylphosphines de formule générale (I), en combinaison avec des composés du groupe des benzilcétals, benzoinéthers, benzoinesters, thioxanthones substitués par alkyle en $C_1$ à $C_4$, chlore ou chlorométhyle, disulfures aromatiques, sulfochlorures de naphtalène, acylphosphines, acylphosphinoxydes et esters acylphosphiniques.

11. Utilisation des sulfures d'acylphosphines selon les revendications 6, 7, 9 ou 10, caractérisée par le fait que le sulfure d'acylphosphine est utilisé en combinaison avec des initiateurs pour la polymérisation thermique.